(19) **Europäisches Patentamt / European Patent Office / Office européen des brevets**

(11) **EP 1 701 216 B1**

(12) **EUROPEAN PATENT SPECIFICATION**

(45) Date of publication and mention
of the grant of the patent:
**12.10.2011 Bulletin 2011/41**

(51) Int Cl.:
***G03F 7/20*** (2006.01)

(21) Application number: **06251118.3**

(22) Date of filing: **01.03.2006**

(54) **Metrology stage for lithography applications**

Messtechnische Trägerplattenvorrichtung für lithographische Anwendungen

Porte-objet de mesure pour applications lithographiques

(84) Designated Contracting States:
**DE FR GB IT NL**

(30) Priority: **03.03.2005 US 657710 P**

(43) Date of publication of application:
**13.09.2006 Bulletin 2006/37**

(73) Proprietor: **ASML Netherlands B.V.**
**5504 DR Veldhoven (NL)**

(72) Inventors:
• **Van de Kerkhof, Marcus Adrianus**
**5708 GT Helmond (NL)**

• **Vos, Harald Petrus Cornelis**
**5223 ZN 's-Hertogenbosch (NL)**

(74) Representative: **van Os, Lodewijk Hubertus et al**
**ASML Netherlands B.V.**
**Corporate Intellectual Property**
**P.O. Box 324**
**5500 AH Veldhoven (NL)**

(56) References cited:
**EP-A- 1 041 357      EP-A- 1 426 826**
**WO-A-2005/015313      US-A- 5 631 731**
**US-A1- 2004 114 150      US-B1- 6 490 031**

## Description

The present invention is related to measurement of lithographic exposure system parameters, and more particularly, to a dedicated metrology stage for lithography applications.

Lithography is a process used to create features on the surface of substrates. Such substrates can include those used in the manufacture of flat panel displays, circuit boards, various integrated circuits, and the like. A frequently used substrate for such applications is a semiconductor wafer. One skilled in the relevant art would recognize that the description herein would also apply to other types of substrates.

During lithography, a wafer, which is disposed on a wafer stage, is exposed to an image projected onto the surface of the wafer by an exposure system located within a lithography system. The exposure system includes a reticle (also called a mask) for projecting the image onto the wafer.

The reticle is generally located between a semiconductor chip and a light source, usually mounted on a reticle stage. In photolithography, the reticle is used as a photo mask for printing a circuit on a semiconductor chip, for example. Lithography light shines through the mask and then through a series of optical lenses that shrink the image. This small image is then projected onto the silicon or semiconductor wafer. The process is similar to how a camera bends light to form an image on film. The light plays an integral role in the lithographic process. For example, in the manufacture of microprocessors, the key to creating more powerful microprocessors is the light's wavelength. The shorter the wavelength, the more transistors can be etched onto the silicon wafer. A silicon wafer with many transistors results in a more powerful microprocessor.

A relatively common problem in the lithographic art is a need to measure parameters of the optical systems used for lithographic exposure. As a general rule, it is desirable to be able to do such measurements without taking the lithographic exposure system offline, and without disassembly and reassembly of components. The current practice in the industry is to place sensors on the wafer stage, to the extent space permits. These sensors are generally located in the space not occupied by the wafer itself, in the corners of the wafer stage.

However, with the ever increasing sophistication of exposure systems, with decreasing exposure wavelengths, and with increasing complexity of the optics, the number of different sensors that end users require is increasing. At the same time, there are severe constraints on the available space. For example, it is generally impractical or undesirable to increase the dimensions of the wafer stage, since this complicates stage positioning, and stage movement, and increases the dimensions of the overall lithographic equipment, which is problematic, since clean room space inside a fabrication facility is limited.

Accordingly, what is needed is a way to enable positioning of measurement sensors of lithographic exposure optics without affecting overall lithographic tool dimensions.

EP 1 041 357 discloses an exposure apparatus used to produce semiconductor devices which includes a measurement stage having an illumination quantity monitor a brightness unevenness sensor and a board for measuring imaging characteristics

US 6 310 679 B discloses a projection exposure apparatus comprising coherence reducing means for increasing the depth of focus when printing isolated patterns. In one embodiment the coherence reducing means is a polarization control member PCM arranged in or in the vicinity of the pupil plane of the projection optical system. A substrate stage WST is provided with means for judging whether the direction of polarization is appropriate or not (column 24, lines 1 - 9).

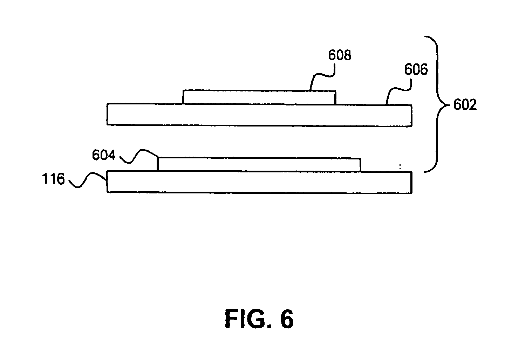

US 2004/114150 A discloses an apparatus for determining the influence on the state of polarization of optical radiation by an optical system under test. In one embodiment the apparatus comprises a polarization sensor which comprises a convex lens, a quarter wavelength plate, a polarizer and a CCD image sensor. The polarization sensor is arranged to measure the state of polarization in a pupil-resolved fashion (paragraphs 61 - 63; figure 6).

According to the present invention there is provided systems comprising a substrate stage and a metrology stage as defined in the appended claims.

In another embodiment of the present invention, the system is within a lithography system, which further comprises an illumination system, a patterning device, and a projection system. The patterning device patterns a beam of radiation from the illumination system. The projection system, which is located within the exposure portion, projects that pattered beam onto the substrate or the sensor system.

In a further embodiment of the present invention, there is provided a method of measuring optical parameters of an exposure portion of a lithography system as defined in the appended claims.

Additional features and advantages of the invention will be set forth in the description that follows, and in part will be apparent from the description, or may be learned by practice of the invention. The advantages of the invention will be realized and attained by the structure and particularly pointed out in the written description and claims hereof as well as the appended drawings. It is to be understood that both the foregoing general description and the following detailed description are exemplary and explanatory and are intended to provide further explanation of the invention as claimed.

The accompanying drawings, which are incorporated herein and form a part of the specification, illustrate one or more embodiments of the present invention and, together with the description, further serve to explain the principles of the invention and to enable a person skilled in the pertinent art to make and use the invention.

FIG. 1 illustrates a metrology stage, according to one embodiment of the present invention.

FIG. 2 schematically illustrates an exemplary lithographic system according to one embodiment of the present invention, which uses the metrology stage.

FIG. 3 shows an exemplary polarization sensor that can be used in the system of FIG. 2, according to one embodiment of the present invention.

FIG. 4 shows an exemplary arrangement of sensors on the metrology stage.

FIG. 5 shows an apodization sensor in the sensors, according to one embodiment of the present invention.

FIGS. 6 and 7 show a stray light sensor in the sensors, according to one embodiment of the present invention.

One or more embodiments of the present invention will now be described with reference to the accompanying drawings. In the drawings, like reference numbers can indicate identical or functionally similar elements. Additionally, the left-most digit(s) of a reference number can identify the drawing in which the reference number first appears.

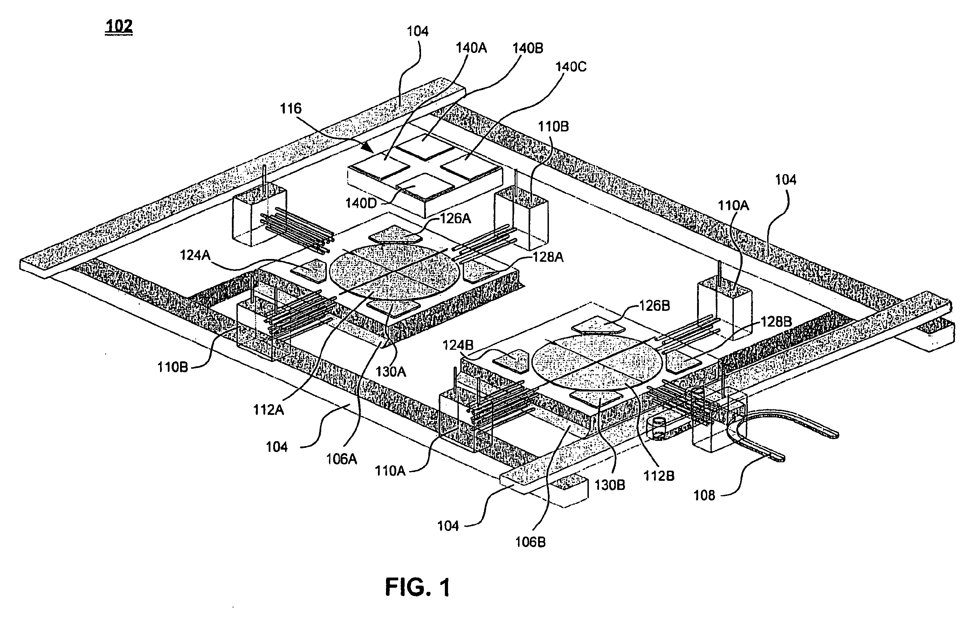

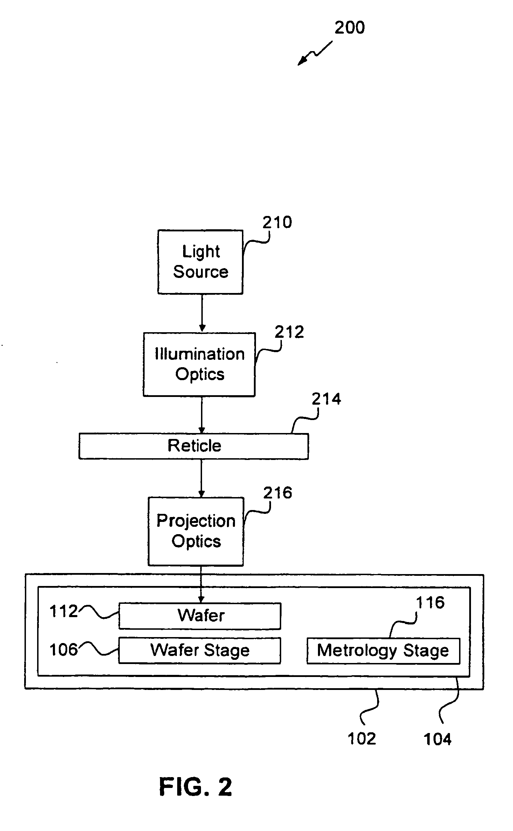

FIG. 1 illustrates one embodiment of the present invention. Shown in FIG. 1 is an isometric three-dimensional view of a substrate handling mechanism 102 of an exposure apparatus (the remainder of the exposure apparatus, such as projection optics, reticle stage, illumination source, etc. are not shown for clarity in FIG. 1, but see discussion below relating to FIG. 2). The substrate handling apparatus 102 has a frame 104, portions of which are shown in FIG. 1. A robot arm 108, or a similar mechanism, is used to move substrates 112 in and out of the substrate handling apparatus 102. Two substrate stages, in this case, labelled 106A and 106B, are located within the substrate handling apparatus 102. The substrate stages 106A, 106B have substrates 112A, 112B located thereon. In alternative examples, the substrates being exposed can be semiconductor wafers or flat panel display (FPD) substrates. Typical dimensions of the substrate stages 106A, 106B is slightly larger than the substrate 112 itself. For current state-of-the-art 12-inch diameter substrates, the substrate stages can be roughly square and on the order of about 13-14 inches in size. In a two-substrate-stage system, one of the substrate stages is typically used for exposure, while the other one is used for measuring of exposure results (for example, measurement of post-process substrate surface height, etc.).

Each substrate stage 106A, 106B has a corresponding actuating system 110A, 110B for moving the substrate stage 106A, 106B. The substrate stages 106A, 106B can have corresponding sensors mounted thereon, designated 124A-130A for substrate stage 106A, and 124B-130B for substrate stage 106B. In one example, that the location of the sensors 124-130 is in the corners of the substrate stages 106, since the substrate 112 is normally in the centre of the substrate stage 106.

Also shown in FIG. 1 is a metrology stage 116, which includes sensors 140A, 140B, 140C and 140D for measurement of optical parameters. It will be understood that the number of sensors 140 on the metrology stage 116 is not particularly limited, although typically the overall dimensions of the metrology stage 116 will be smaller than the dimensions of the substrate stages 106.

In one example, the vertical dimension of the sensors 124-130 placed on the substrate stages 106 may be limited for various reasons. For example, the minimum height of the substrate stage 106 and the location of the lowest element of the projection optics (not shown in the figure) can limit the vertical dimensions of the sensors 124-130 on the substrate stage 106. In one example, with respect to the metrology stage 116, since the metrology stage 116 can be "thinner" than the substrate stage 106, the sensors 140 can be "taller" than the sensors 124-130. Also, in one example, the substrate stages 106 can be made smaller in the X-Y (horizontal) dimension (for example, the "corners" can be "cut off," resulting in a "footprint" of the substrate stage that is smaller than the roughly square shape shown in FIG. 1), realizing space savings.

FIG. 2 schematically illustrates an exemplary lithographic system 200 according to one embodiment of the present invention, which uses the metrology stage 116. As shown in FIG. 2, the lithographic system 200 (shown in side view) includes a light source (illumination source) 210, such as a laser or a lamp, illumination optics 212 (such as a condenser lens), and a patterning device (e.g., reticle, mask, spatial light modulator, etc., hereinafter reticle will be used) 214, which is usually mounted on a patterning device stage (not shown). Note that the reticle 214 can be a plate with an exposure pattern on it. In an alternative example, the reticle can be replaced with a dynamic patterning device, such as an array of programmable elements or a spatial light modulator array, such as used in maskless lithography. Light from the reticle 214 is imaged onto the substrate 112 using projection optics 216. The substrate 112 is mounted on the substrate stage 106 (only one of the two substrate stages is shown in this figure, as the invention is not limited to any particular number of substrate stages). Also shown in FIG. 2 is the housing 104 (which can enclose only the substrate stage 106 and the metrology stage 116, or can enclose other components illustrated in the figure).

The sensors 140 (see FIG. 1) include a polarization sensor, which is particularly useful for measurement of time-varying polarization (absolute and relative) properties of the projection optics. The polarization sensor is one sensor where the ability to install sensors that have a substantial height becomes particularly important.

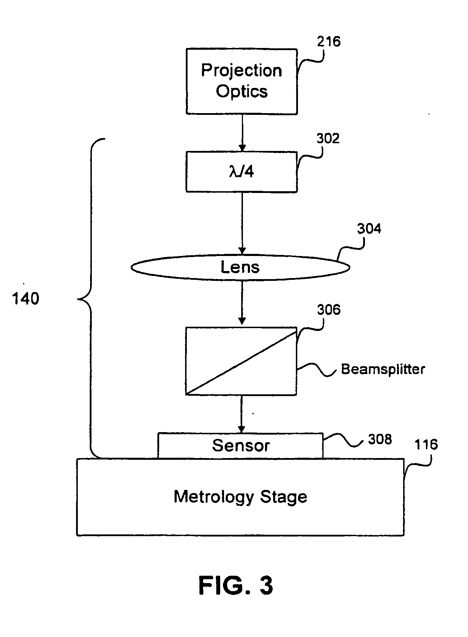

FIG. 3 shows an exemplary polarization sensor that can be used in the system of FIG. 2, according to one embodiment of the present invention. The polarization sensor includes a quarter wavelength plate **302,** a collimator lens **304,** a polarizer **306,** a detector **308,** and a mechanism for rotating the quarter wavelength plate **302.**

The polarizer (analyser) **306** is located downstream of the projection optics **216** and positioned in the optical path. The polarizer **306** passes one particular polarization of the incoming light that can then be measured in the metrology stage **116.** Examples of polarizers can be such optical components as polarizing plates, polarizing beam splitters, etc. Such optical components are frequently relatively volume-intensive, for example, on the order of several cubic centimetres. Furthermore, such optical components are usually very limited in angular range (i.e., in terms of angle of incidence), usually on the order of less than 1 degree, and frequently substantially less than 1 degree. At the same time, the projection optics **216** is typically a high numerical aperture lens, or set of lenses, which is mismatched to the very small angular range of the optical components, such as polarizing beamsplitters.

In one example, in order to use such a polarizer **306,** it is necessary to shape the beam appropriately. In one example, such shaping is done by means of a collimator lens **304** (or set of lenses). The collimator lens **304** is also relatively difficult to miniaturize, and often has a volume of several cubic centimetres. Furthermore, it is frequently desirable to measure not just one polarization, but a range of polarizations. To accomplish this, in one example the entire polarization sensor needs to be rotated, while in another example a quarter wavelength plate **302** can be inserted into the beam path (for example, between the collimator lens **304** and projection optics **216**) and can then be rotated to select the appropriate polarization. A detector **308,** (charged coupled device (CCD) array or, not forming part of the invention, a photodiode), is positioned such that the detector **308** is at the proper focus and is aligned in the X-Y plane (note that this is an imaging measurement, and it is important to properly position the detector).

From the description above, it can be seen that the entire polarization sensor, including the quarter wavelength plate **302,** collimator lens **304,** polarizer **306,** CCD array **308,** and a mechanism for rotating the quarter wavelength plate **302,** occupies relatively large volume. For example, this volume can be on the order of several cubic centimetres, which given the "cramped" dimensions available to the designer of the lithographic tool, makes it relatively impractical to use such polarization sensors, if they need to be mounted on conventional substrate stages. However, since the metrology stage **116** can be made thinner, the polarization sensor, an example of which is described above, can be installed on the metrology stage **116.**

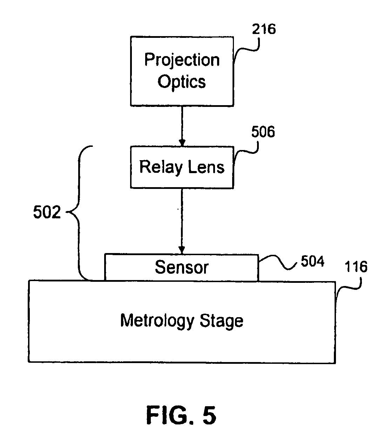

**FIG. 5** shows an apodization sensor **502** in the sensors **140,** according to one embodiment of the present invention. The apodization sensor **502** measures the intensity of the exposure beam as a function of distance from the optical axis in the XY plane (image plane). This is also an imaging measurement. The apodization sensor **502** is another example of a sensor where vertical height requirements can make it impractical to mount such a sensor on a conventional substrate stage. In one example, the apodization sensor **502** includes a CCD array **504** that "looks" into the pupil of the projection optics **216.** Generally, the CCD array **504** needs to be optically conjugate with the pupil of the projection optics **216.** This requires the use of a relay lens **506** between the charge coupled device **504** and the projection optics **216.** In one example, the relay lens **504** has a dimension on the order of several millimetres or even a few centimetres. Thus, mounting such an apodization sensor **502** on a conventional substrate stage is extremely difficult.

In one example, a CCD array **504** for an apodization sensor **502** measures the light intensity in the image plane as a function of (X,Y) and is preferably at least the size of the exposure field in the image plane. In one example, an exposure field is several tens of millimetres by several millimetres in size and on the order of about 26 millimetres by 10 millimetres in size (although the exposure field in many state of the art lithography tools is generally increasing in size over time). Thus, the CCD array **504** is at least as large, or somewhat larger, in size, as the exposure field.

In one example, the apodization sensor **502** can be used to verify the numerical aperture of the system. Such a measurement may be desired by the end user to confirm that the system performs to specification, i.e., works "as advertised." It should be noted that the numerical aperture measurement is a one-time (or, at most, relatively rare) measurement, compared to many other measurements that need to be performed much more frequently.

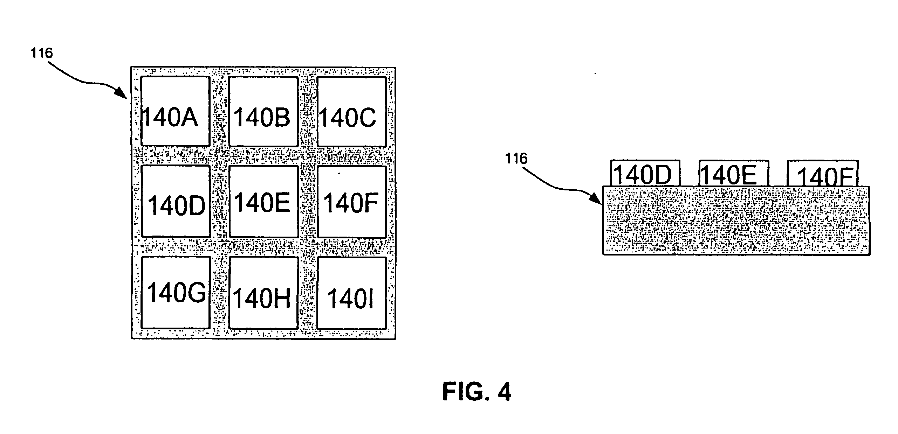

**FIG. 4** shows an exemplary arrangement of sensors on the metrology stage (with the top view and side view shown). In this case, nine sensors **140A-140I** are shown in a grid pattern arrangement. Any of the sensors discussed above or below can be one of these nine sensors **140A-140I,** having the arrangement and structures as described, which are not shown for convenience.

In one example, the sensors **140A-140I** can include a sensor to measure slit uniformity, if slits are used in the lithographic optics. This is a measure of illumination source quality. A typical high-end lithographic system, as noted above, exposes an area on a substrate that is several tens of millimetres by several millimetres in size, depending on the manufacturer of the lithographic system, for example, about 26 millimetres by 10 millimetres. For nomenclature purposes, the 26 millimetre dimension is usually referred to as "X," and the 10 millimetre dimension is usually referred to as "Y." Ideally, the optical system is able to image a perfect "rectangle" that has an intensity distribution that is uniform throughout the rectangle. A slit uniformity sensor is designed to measure whether the "uniform rectangle" that is imaged is in fact uniform, and if not, how far it deviates from uniformity.

This can be accomplished, for example, through the use of a integrating precision photodiode that is scanned in the Y direction. The photodiode can have a pinhole, or a slit, "on top" of it, to limit the amount of light that reaches the photodiode.

It should also be noted that a charged couple device normally cannot be used for this purpose, because most CCDs drift over time. What is of primary interest in the slit uniformity measurement is absolute values of intensity (in addition to relative intensity as a function of X,Y distance), since it is important to accurately relate the voltage from the photodiode to the amount of light received by the photoresist. Note also that the use of a precision photodiode permits a better signal-to-noise ratio. The photodiode provides an integration of the received light in the Y direction, either by moving the photodiode or by integrating using a slit.

In one example, the sensors **140A-140I** can include a wavefront sensor to measure the quality of the wavefront image, as well as any aberrations. An example of such a wavefront sensor is an ILIAS sensor (Inline Lens Interferometric System) to measure the quality of the wavefront. It should be noted that although ILIAS sensors have been used in the past, one problem with such sensors in conventional systems is the need to measure the "far field" due to the lack of space for a relay lens, or a collimator lens. As discussed above, the ILIAS sensor can include such a relay and/or collimator lens, to substantially improve performance of the ILIAS sensor, and therefore, of the measurement of the quality of the wave front and the aberrations.

In one example, the sensors **140A-140I** can include a sensor to measure image contrast. The contrast sensor measures the quantity

$$\frac{Maximum\ Intensity - Minimum\ Intensity}{Maximum\ Intensity + Minimum\ Intensity}$$

in the image plane. One way to implement the contrast sensor is to have slits on the reticle, with the slits arranged to have a certain pitch. One photodetector, or one single photodetector per pitch can be used in the image plane. With perfect contrast, the slits in the reticle (in the object plane) will form "lines of light" in the image plane and perfectly dark areas outside of the lines of light. In practice, this may be unachievable and there is always some signal that will be measured even in the "dark areas." The contrast sensor therefore provides a measurement of the relative intensity between the light areas and the dark areas.

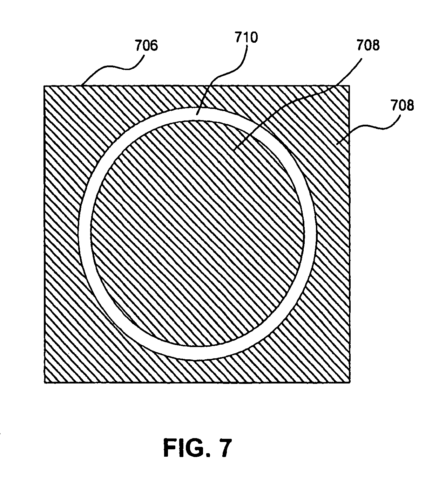

**FIGS. 6** and **7** show a stray light sensor **602** in the sensors **140A-140I,** according to one embodiment of the present invention. **FIG. 7** shows an alternative embodiment of the plate portion **706** of sensor **602,** according to one embodiment of the present invention. Sensor **602** can measure stray light (which can be due to contamination of the optics). The stray light sensor **602** essentially measures intensity in the image plane as a function of radial distance from the optical axis. In one example, this is done by creating a point source in the object plane, in other words, the reticle functions as a point source, rather than as a mask for exposure. Ideally, the point source images into a point in the image plane. The stray light sensor **602** can also include a transmissive glass plate **606** with chrome **608** (or other metal) blocking the light from the point source. The glass plate **606** is positioned in the image plane. A detector **604,** for example, as a photo detector or a CCD array is positioned below the glass plate. The detector can also be an integrating photodiode.

In the example shown in **FIG. 7.,** in addition to the central portion having chrome **708** blocking the light from the point source, a ring shaped annulus **710** is left open, with the remaining portion of the glass plate **706** also covered by chrome or metal **708.** Thus, the sensor **602** measures the amount of light received at a distance r (i.e., I(r)) from the optical axis, which, with the point source blocked, represents stray light. Different glass plates, with different radii of the annulus can be used to "step through" the various distances r. It will be appreciated that other arrangements of sources in the object plane, detectors and blocking elements (like glass plates) are possible.

In one example, the sensors **140A-140I** can include a focus sensor, to sense the location of the focus (image) plane in the vertical direction. The focus sensor is typically a photodiode that is initially placed at the expected location of the focus, and light intensity is measured. The photodiode is then moved in three degrees of freedom (X, Y and Z) to locate the maximum, which is then taken to be the location of the focus.

In one example, the sensors **140A-140I** can include a sensor to measure alignment of the reticle, functioning in a manner similar to the focus sensor (to find the maximum intensity at a point of alignment).

While various embodiments of the present invention have been described above, it should be understood that they have been presented by way of example only, and not limitation. Thus, the breadth and scope of the present invention should not be limited by any of the above-described exemplary embodiments, but should be defined only in accordance with the scope of the following claims.

**Claims**

1.  A system (102), comprising:

    a substrate stage (106A) that is configured to position a substrate (112A) receive an exposure beam from an exposure system of a lithography system; and

a metrology stage (116) having a sensor system (140) thereon that is configured to detect parameters of the exposure system or the exposure beam; wherein the sensor system comprises a relative or absolute polarization sensor comprising:

a quarter wavelength plate (302);
a collimator lens (304);
a polarizer (306); and
a charge coupled device array (308);

2. A system according to claim 1, wherein the sensor system further comprises an apodization sensor (502) comprising:

a relay lens (506); and
a charge coupled device array (504) toptically conjugate with a pupil of an optical system (216) of the exposure system.

3. A system according to claim 1 or 2, wherein the sensor system further comprises a stray light sensor (602) comprising
a plate (706) having an absorptive coating (708) thereon, wherein the coating forms an annular transmissive region (710); and
a photodetector (604) for sensing light passing through the annular transmissive region.

4. A system according to any one of the preceding claims, further comprising:

a second substrate stage (106B) that is configured to position a second substrate (112B) to receive the exposure beam from the exposure portion of the lithography system.

5. A system according to any one of the preceding claims, wherein the metrology stage (116) is smaller than a diameter of the substrate.

6. A lithography system (200), comprising:

an illumination system (212) that produces a beam of radiation;
a patterning device (214) that patterns the beam;
a projection system (216) that projects the patterned beam onto a substrate; and
a system according to any one of the preceding claims.

7. A method of measuring optical parameters of an exposure portion of a lithography system (200), the method comprising:

moving a substrate stage (106) away from an optical axis of the exposure portion;

moving a metrology stage (116) to locate a sensor in the optical axis; and
measuring an optical parameter of light from the exposure system;

wherein:

the measurement comprises a polarization measurement comprising:

transmitting the light from the exposure system through a quarter wavelength plate (302), a collimator lens (304), and a polarizer (306) and onto a charge coupled device array (308).

8. A method according to claim 7, wherein the measurement further comprises an apodization measurement comprising:

transmitting the light from the exposure system through a relay lens (506) and onto a charge coupled device (504) optionally conjugate a pupil of the projection optics (216).

9. A method according to claim 7 or 8, wherein the measurement further comprises a stray light measurement comprising:

transmitting the light from the exposure system through a plate (706) having an absorptive coating (708) thereon, wherein the coating forms an annular transmissive region (710), and onto a photodetector (604) for sensing light passing through the annular transmissive region.

10. A device manufacturing method comprising: measuring an optical parameter of a lithographic apparatus according to the method of any one of claims 7 to 9; and exposing substrates using the lithographic apparatus, a setting of the exposure being determined in accordance with the measured parameter.

**Patentansprüche**

1. Ein System (102), das Folgendes beinhaltet:

einen Substrattisch (106A), der konfiguriert ist, um ein Substrat (112A) zum Empfangen eines Belichtungsstrahls von einem Belichtungssystem eines Lithographiesystems zu positionieren; und
einen Messtisch (116) mit einem Sensorsystem (140) darauf, das konfiguriert ist, um Parameter des Belichtungssystems oder des Belichtungsstrahls zu erfassen; wobei das Sensorsystem einen Sensor der relativen oder absoluten Polarisation beinhaltet, der Folgendes beinhaltet:

eine Viertelwellenlängenplatte (302);
eine Kollimatorlinse (304);
einen Polarisator (306) und
eine ladungsgekoppelte Vorrichtungsanordnung (308).

2. System gemäß Anspruch 1, wobei das Sensorsystem ferner einen Apodisationssensor (502) beinhaltet, der Folgendes beinhaltet:

eine Relaislinse (506) und
eine ladungsgekoppelte Vorrichtungsanordnung (504), die optisch mit einer Pupille eines optischen Systems (216) des Belichtungssystems konjugiert ist.

3. System gemäß Anspruch 1 oder 2, wobei das Sensorsystem ferner einen Streulichtsensor (602) beinhaltet, der Folgendes beinhaltet:

eine Platte (706) mit einer absorbierenden Beschichtung (708) darauf, wobei die Beschichtung eine ringförmige durchlässige Region (710) bildet, und
einen Photodetektor (604) zum Wahrnehmen von Licht, das durch die ringförmige durchlässige Region geht.

4. System gemäß einem der vorhergehenden Ansprüche, das ferner Folgendes beinhaltet:

einen zweiten Substrattisch (106B), der konfiguriert ist, um ein zweites Substrat (112B) zum Empfangen des Belichtungsstrahls von dem Belichtungsabschnitt des Lithographiesystems zu positionieren.

5. System gemäß einem der vorhergehenden Ansprüche, wobei der Messtisch (116) kleiner als ein Durchmesser des Substrats ist.

6. Ein Lithographiesystem (200), das Folgendes beinhaltet:

ein Beleuchtungssystem (212), das einen Strahl aus Strahlung produziert;
eine Musteraufbringungsvorrichtung (214), die den Strahl mustert;
ein Projektionssystem (216), das den gemusterten Strahl auf ein Substrat projiziert; und
ein System gemäß einem der vorhergehenden Ansprüche.

7. Ein Verfahren zum Messen optischer Parameter eines Belichtungsabschnitts eines Lithographiesystems (200), wobei das Verfahren Folgendes beinhaltet:

Wegbewegen eines Substrattisches (106) von einer optischen Achse des Belichtungsabschnitts;
Bewegen eines Messtisches (116), um einen Sensor in der optischen Achse anzuordnen; und
Messen eines optischen Parameters von Licht aus dem Belichtungssystem;
wobei:

die Messung eine Polarisationsmessung beinhaltet, die Folgendes beinhaltet:

Senden des Lichts aus dem Belichtungssystem durch eine Viertelwellenlängenplatte (302), eine Kollimatorlinse (304) und einen Polarisator (306) und auf eine ladungsgekoppelte Vorrichtungsanordnung (308).

8. Verfahren gemäß Anspruch 7, wobei die Messung ferner eine Apodisationsmessung beinhaltet, die Folgendes beinhaltet:

Senden des Lichts aus dem Belichtungssystem durch eine Relaislinse (506) und auf eine ladungsgekoppelte Vorrichtung (504), die optisch mit einer Pupille der Projektionsoptik (216) konjugiert ist.

9. Verfahren gemäß Anspruch 7 oder 8, wobei die Messung ferner eine Streulichtmessung beinhaltet, die Folgendes beinhaltet:

Senden des Lichts aus dem Belichtungssystem durch eine Platte (706) mit einer absorbierenden Beschichtung (708) darauf, wobei die Beschichtung eine ringförmige durchlässige Region (710) bildet, und auf einen Photodetektor (604) zum Wahrnehmen von Licht, das durch die ringförmige durchlässige Region geht.

10. Ein Verfahren zur Herstellung einer Vorrichtung, das Folgendes beinhaltet: Messen eines optischen Parameters eines lithographischen Geräts gemäß dem Verfahren aus einem der Ansprüche 7 bis 9; und Belichten von Substraten unter Verwendung des lithographischen Geräts, wobei eine Einstellung der Belichtung gemäß dem gemessenen Parameter bestimmt wird.

**Revendications**

1. Un système (102), comprenant :

une platine porte-substrat (106A) qui est configurée pour positionner un substrat (112A) pour qu'il reçoive un faisceau d'exposition provenant d'un système d'exposition d'un système de lithographie ; et

une platine de métrologie (116) présentant sur elle un système de capteurs (140) qui est configuré pour détecter des paramètres du système d'exposition ou du faisceau d'exposition ; dans lequel le système de capteurs comprend un capteur de polarisation relative ou absolue comprenant :

une lame quart de longueur d'onde (302) ;
une lentille collimateur (304) ;
un polariseur (306) ; et
une matrice de dispositif à transfert de charge (308).

2. Un système selon la revendication 1, dans lequel le système de capteurs comprend en outre un capteur d'apodisation (502) comprenant :

une lentille de relais (506) ; et
une matrice de dispositif à transfert de charge (504) conjuguée optiquement à une pupille d'un système optique (216) du système d'exposition.

3. Un système selon la revendication 1 ou la revendication 2, dans lequel le système de capteurs comprend en outre un capteur de lumière parasite (602) comprenant
une plaque (706) présentant sur elle un revêtement absorbant (708), dans lequel le revêtement forme une région transmissive annulaire (710) ; et
un photodétecteur (604) destiné à capter de la lumière passant à travers la région transmissive annulaire.

4. Un système selon l'une quelconque des revendications précédentes, comprenant en outre :

une deuxième platine porte-substrat (106B) qui est configurée pour positionner un deuxième substrat (112B) pour qu'il reçoive le faisceau d'exposition de la portion d'exposition du système de lithographie.

5. Un système selon l'une quelconque des revendications précédentes, dans lequel la platine de métrologie (116) est plus petite qu'un diamètre du substrat.

6. Un système de lithographie (200), comprenant :

un système d'illumination (212) qui produit un faisceau de rayonnement ;
un dispositif servant à conformer selon un motif (214) qui conforme le faisceau selon un motif ;
un système de projection (216) qui projette le faisceau à motif sur un substrat ; et
un système selon l'une quelconque des revendications précédentes.

7. Un procédé pour mesurer des paramètres optiques d'une portion d'exposition d'un système de lithographie (200), le procédé comprenant :

déplacer une platine porte-substrat (106) afin de l'écarter d'un axe optique de la portion d'exposition ;
déplacer une platine de métrologie (116) afin de placer un capteur dans l'axe optique ; et
mesurer un paramètre optique de lumière provenant du système d'exposition ;
dans lequel :

la mesure comprend une mesure de polarisation comprenant :

transmettre la lumière provenant du système d'exposition à travers une lame quart de longueur d'onde (302), une lentille collimateur (304), et un polariseur (306) et sur une matrice de dispositif à transfert de charge (308).

8. Un procédé selon la revendication 7, dans lequel la mesure comprend en outre une mesure d'apodisation comprenant :

transmettre la lumière provenant du système d'exposition à travers une lentille de relais (506) et sur un dispositif à transfert de charge (504) conjugué optiquement à une pupille du système de projection optique (216).

9. Un procédé selon la revendication 7 ou la revendication 8, dans lequel la mesure comprend en outre une mesure de lumière parasite comprenant :

transmettre la lumière provenant du système d'exposition à travers une plaque (706) présentant sur elle un revêtement absorbant (708), dans lequel le revêtement forme une région transmissive annulaire (710), et sur un photodétecteur (604) destiné à capter de la lumière passant à travers la région transmissive annulaire.

10. Un procédé de fabrication de dispositif comprenant : mesurer un paramètre optique d'un appareil lithographique selon le procédé de l'une quelconque des revendications 7 à 9 ; et exposer des substrats à l'aide de l'appareil lithographique, un réglage de l'exposition étant déterminé conformément au paramètre mesuré.

**FIG. 1**

200

210

Light
Source

212

Illumination
Optics

214

Reticle

216

Projection
Optics

112 — Wafer

106 — Wafer Stage

116

Metrology Stage

102        104

FIG. 2

216

Projection
Optics

302

λ/4

304

Lens

140

306

Beamsplitter

Sensor    308    116

Metrology Stage

**FIG. 3**

11

**FIG. 4**

FIG. 5

FIG. 6

FIG. 7

**EP 1 701 216 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1041357 A
- US 6310679 B
- US 2004114150 A